# EUROPEAN PATENT SPECIFICATION

(11) **EP 3 321 958 B1**
(45) Date of publication and mention of the grant of the patent: **31.03.2021**
(21) Application number: 16880542.2
(22) Date of filing: 14.07.2016
(51) Int. Cl.: H01L 23/373, C09K 5/14, B82Y 30/00, B82Y 40/00, F28F 3/00, F28F 21/02

(54) **METHOD FOR MANUFACTURING THERMAL INTERFACE MATERIAL**
VERFAHREN ZUR HERSTELLUNG EINES THERMISCHEN SCHNITTSTELLENMATERIALS
PROCÉDÉ DE FABRICATION D'UN MATÉRIAU D'INTERFACE THERMIQUE

(30) Priority: 29.12.2015 CN 201511009829
(43) Date of publication of application: 16.05.2018
(73) Proprietor: Huawei Technologies Co., Ltd., Longgang District Shenzhen, Guangdong 518129 (CN)
(72) Inventor: NIHEI, Mizuhisa, Shenzhen, Guangdong 518129 (CN); ZHOU, Xiaosong, Shenzhen, Guangdong 518129 (CN); OTA, Keishin, Tsukuba City, Ibaraki 300-2651 (JP)
(74) Representative: Thun, Clemens
(86) International application number: PCT/CN2016/090003
(87) International publication number: WO 2017/113745

(56) References cited:
- EP-A1- 2 763 167
- EP-A1- 2 863 426
- WO-A1-2015/180135
- CN-A- 101 899 288
- CN-A- 103 367 275
- CN-A- 105 679 723
- US-A1- 2006 231 946
- US-A1- 2008 083 612
- US-A1- 2008 131 655
- US-B2- 8 617 650

## Description

### TECHNICAL FIELD

The present invention relates to the field of material technologies, and in particular, to a method for preparing a thermal interface material.

### BACKGROUND

Heat generated by a heating element, such as a chip, in an electronic device usually needs to be dissipated to the outside by using a heat dissipation component. From a micro perspective, much roughness exists on a contact interface between the heating element and the heat dissipation component, and a thermal interface material (Thermal Interface Materials, TIM) needs to be used to fill the contact interface between the heating element and the heat dissipation component, to reduce contact thermal resistance.

Currently, a thermal interface material with a relatively good heat conducting effect in the industry is formed by growing a carbon nanotube array on two surfaces of a metal zirconium foil. However, interface thermal resistance of the metal zirconium foil in the thermal interface material is relatively large. Therefore, a heat conducting property of the thermal interface material is relatively poor.

### SUMMARY

In accordance with the present invention, this application provides a method for preparing a thermal interface material.

In particular, a method for preparing a thermal interface material is provided, including:
growing carbon nanotubes on two surfaces of a zirconium foil to form a carbon nanotube array on each of the two surfaces of the zirconium foil, wherein the two surfaces comprise zirconium oxide;
placing, in an H₂ atmosphere for annealing reduction processing, the zirconium foil with the carbon nanotube array grown on the two surfaces; and
performing the annealing reduction processing, wherein in the process of the annealing reduction processing in the H₂ atmosphere, an H₂ flow rate is 5 to 100 SCCM, atmospheric pressure is 0.005 to 0.5 MPa, annealing processing temperature is 350°C to 650°C, and a duration of the annealing processing is 5 to 30 min, thereby performing a reduction reaction on the two surfaces of the zirconium foil after the carbon nanotube array is formed on each of the two surfaces of the zirconium foil to obtain the thermal interface material, wherein the two surfaces of the zirconium foil in the thermal interface material comprise, after the annealing reduction processing, on an interface between the zirconium foil and each carbon nanotube of the carbon nanotube array zirconium and on the remaining parts of the two surfaces exposed zirconium.

The method of the present invention is defined in claim 1.

In a possible implementation of the present invention, after the performing a reduction reaction on the two surfaces of the zirconium foil, the method further includes:
filling a gap between two adjacent carbon nanotubes in the carbon nanotube array with resin in a vacuum by using an evaporation technology, to obtain the thermal interface material, so that the zirconium is no longer exposed between the two adjacent carbon nanotubes.

According to the present invention, the first surface and the second surface of the metal zirconium foil include the exposed metal zirconium. Therefore, the interface thermal resistance of the thermal interface material is reduced, and the heat conducting property of the thermal interface material is improved.

### BRIEF DESCRIPTION OF DRAWINGS

FIG. 1 is a schematic diagram of a thermal interface material;
FIG. 2 is a schematic diagram of another thermal interface material;
FIG. 3 is a schematic diagram of a heat dissipation system; and
FIG. 4 is a schematic diagram of an embodiment of a method for preparing a thermal interface material in this application.

### DESCRIPTION OF EMBODIMENTS

This application provides a method for preparing a thermal interface material, so that interface thermal resistance of the thermal interface material is reduced, and a heat conducting property of the thermal interface material is improved.

To make persons skilled in the art understand the technical solutions of the present invention better, the following clearly and completely describes the technical solutions in this application with reference to the accompanying drawings in this application. Apparently, the described embodiments are merely a part rather than all of the embodiments of the present invention. All other embodiments obtained by persons of ordinary skill in the art based on the embodiments of the present invention without creative efforts shall fall within the protection scope of the present invention.

In the specification, claims, and accompanying drawings of the present invention, the terms "first", "second", and so on (if they exist) are intended to distinguish between similar objects but do not necessarily indicate a specific order or sequence. It should be understood that the data termed in such a way are interchangeable in proper circumstances so that the embodiments described herein can be implemented in other orders than the order illustrated or described herein. Moreover, the terms "include", "have", and any other variants mean to cover the non-exclusive inclusion, for example, a process, method, system, product, or device that includes a list of steps or units is not necessarily limited to those units, but may include other steps or units not expressly listed or inherent to such a process, method, system, product, or device.

Related basic concepts in the embodiments of this application are first briefly described below.

Carbon nanotube: is also referred to as a Bucky tube, and is a one-dimensional quantum material with a special structure (a radial dimension is of a nanometer level, an axial dimension is of a micrometer level, and basically, both two ends of the tube are sealed). The carbon nanotube is several layers to dozens of layers of coaxial round tubes that mainly include carbon atoms arranged in a hexagon. There is a fixed distance between layers. The distance is approximately 0.34 nm, and a diameter is usually 2 to 20 nm. In addition, according to different directions along axial directions of carbon hexagons, carbon nanotubes are categorized into three types: zigzag-shaped, armchair-shaped, and spiral. A spiral carbon nanotube has chirality, but zigzag-shaped and armchair-shaped carbon nanotubes do not have chirality. Due to a special molecular structure, the carbon nanotube has an obvious electronic property. The carbon nanotube is widely applied to nanoelectronics and optoelectronics, a field emission electron source, a high-strength composite material, a sensor and an actuator, a heat conducting material, an optical material, a conductive film, a nanometer-level template and hole, and the like.

Ethyne: A molecular formula thereof is C2H2. The ethyne is commonly known as air coal and acetylene, and is a member with a smallest volume in an alkyne compound series. The ethyne is mainly for industrial use, for example, growing carbon nanotubes. The ethyne is colorless and extremely flammable gas at room temperature.

Argon: is a nonmetallic element whose element symbol is Ar. Argon is a monatomic molecule, and an elementary substance thereof is colorless, odorless, and tasteless gas. Argon is noble gas with a highest content in the air, and is currently first-discovered noble gas due to a quite high content in the natural world. Argon is extremely chemically inactive. However, a compound of argon, that is, argon fluorohydride has already been manufactured. Argon cannot be combusted, nor is combustion-supporting, and is usually used as protective gas.

An evaporation technology is a method in which metal, an alloy, or a compound used for plating is heated in a vacuum chamber until the metal, the alloy, or the compound melts, so that the metal, the alloy, or the compound effuses in a state of a molecule or an atom, and is deposited on a surface of a to-be-plated material, to form a solid film or coating.

SCCM: is a unit of a volume flow rate. A full English name is standard-state cubic centimeter per minute. SCCM is commonly used in a chemical reaction.

Torr: is a unit of pressure. Originally, 1 Torr is "pressure that lifts mercury in a slim straight pipe by 1 millimeter". However, regular atmospheric pressure can lift the mercury by 760 mm. Therefore, 1 Torr is defined as 1/760 of the atmospheric pressure.

A thermal interface material is described below.

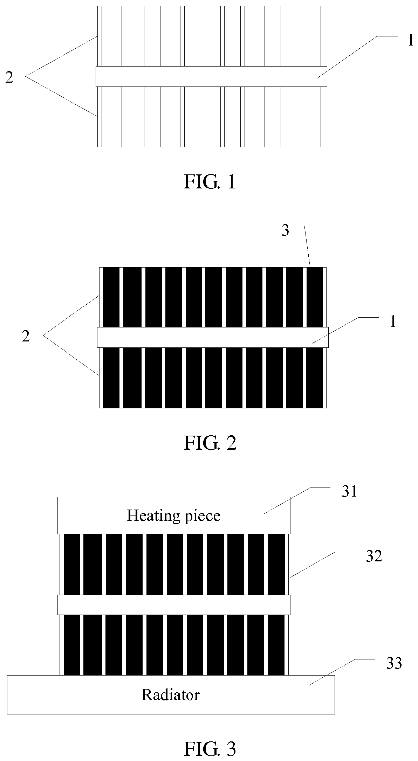

As shown in FIG. 1, the thermal interface material includes a metal zirconium foil 1 and carbon nanotube arrays 2. The metal zirconium foil 1 has a first surface and a second surface that is opposite to the first surface. Carbon nanotubes in the carbon nanotube arrays 2 are distributed on the first surface and the second surface, and the first surface and the second surface of the metal zirconium foil 1 include exposed metal zirconium.

In this example, the first surface and the second surface of the metal zirconium foil include the exposed metal zirconium. Therefore, interface thermal resistance of the thermal interface material is reduced, and a heat conducting property of the thermal interface material is improved.

In this example, to further reduce the interface thermal resistance of the thermal interface material and improve the heat conducting property of the thermal interface material, both the first surface and the second surface of the metal zirconium foil may be the exposed metal zirconium.

Optionally, the carbon nanotubes in the carbon nano arrays are perpendicular to the first surface and the second surface. It should be noted that, herein, the carbon nanotubes in the carbon nano arrays are perpendicular to the first surface and the second surface, but in actual production, not all the carbon nanotubes are perpendicular to the first surface and the second surface. It may be considered that the carbon nanotubes in the carbon nano arrays are perpendicular to the first surface and the second surface provided that an error percentage in the prior art is met. In this case, density of the carbon nanotubes in the carbon nanotube array is relatively even, and there is no density difference that is caused because directions of all the carbon nanotubes are towards a specific side.

The interface thermal resistance of the thermal interface material is mainly caused by air that is on an interface and that is between metal oxide on a surface of a metal substrate and a carbon nanotube. In addition, even in a high-density carbon nanotube array, there is still air between carbon nanotubes. Therefore, to reduce the interface thermal resistance of the thermal interface material, a material with higher heat conductivity may be used to replace the air and is filled between the carbon nanotubes. Optionally, as shown in FIG. 2, a gap between two adjacent carbon nanotubes in the carbon nanotube array is filled with resin, and the resin may be, for example, silicon resin.

When the gap between two adjacent carbon nanotubes in the carbon nanotube array is filled with the resin, further preferably, heat conductivity of the resin is greater than 0.1 W/m.k. In this case, the heat conducting property of the thermal interface material can be ensured.

In some embodiments of this application, among the nanotubes in the carbon nanotube arrays, density of a carbon nanotube array distributed on the first surface is the same as density of a carbon nanotube array distributed on the second surface. It may be understood that the density being the same described herein does not mean that the density is absolutely the same. Instead, in a technology in the art, there is no obvious difference that affects an effect provided that a density difference percentage is met and that the density of the carbon nanotube array distributed on the first surface and the density of the carbon nanotube array distributed on the second surface are even.

The carbon nanotubes in the carbon nanotube arrays are evenly distributed on the first surface and the second surface of the metal zirconium foil. Therefore, when the thermal interface material in this example is used, the thermal interface material can be in better contact with a radiator interface, so that the heat conducting property is improved.

In the thermal interface material including the carbon nanotube, higher mass density of the carbon nanotubes in the thermal interface material leads to a better heat conducting effect of the thermal interface material. In this application, the mass density of the carbon nanotubes in the thermal interface material reaches 0.16 to 0.5 g/cm3, and the density may be approximately 10 times mass density of carbon nanotubes in a thermal interface material produced by using a regular growth technology, so that the heat conducting property of the thermal interface material is greatly improved. Preferably, the mass density of the carbon nanotubes in the thermal interface material is 0.3 to 0.5 g/cm3.

Because the carbon nanotubes in this application are in high density, specific thickness of the metal zirconium foil needs to be ensured. Otherwise, even if the carbon nanotubes are evenly distributed, the metal zirconium foil may be prone to deformation. Therefore, the thickness of the metal zirconium foil may be 10 to 100 µm, and preferably, 30 to 60 µm.

Optionally, in this application, the carbon nanotubes may be multi-walled carbon nanotubes. A diameter of the carbon nanotube may be 10 to 20 nm, and a length may be 30 to 100 µm.

Optionally, the gap between two adjacent carbon nanotubes in the carbon nanotube array is 10 to 100 nm. A smaller gap between the carbon nanotubes leads to larger density of the carbon nanotubes and a better heat conducting effect. Certainly, when the gap between the carbon nanotubes is extremely small, the density of the carbon nanotubes can be further increased. However, when a carbon tube gap of the carbon nanotubes is small to a specific extent, during carbon nanotube growth, growth quality of the carbon nanotubes is prone to degrade and growth difficulty of the carbon nanotubes is increased because of excessively large density. This is mainly due to restriction of a flow rate of carbon source gas (for example, C2H2). (That is, the gas cannot smoothly pass through when the carbon nanotubes are extremely dense, and consequently, sufficient and stable carbon sources cannot be provided, and some carbon nanotubes stop growing). Therefore, the gap between the carbon nanotubes needs to be a proper distance. In this embodiment of this application, the gap between two adjacent carbon nanotubes in the carbon nanotube array is 10 to 100 nm, so that not only the heat conducting effect of the carbon nanotube array is ensured, but difficulty for growing the carbon nanotube array is not increased. Further preferably, the gap between two adjacent carbon nanotubes in the carbon nanotube array is 30 to 70 nm.

In an example of this application, a thermally conductive pad is further provided. The thermally conductive pad is made of the foregoing thermal interface material.

In an example of this application, a heat dissipation system is further provided. As shown in FIG. 3, the heat dissipation system includes a heating piece 31, a radiator 32, and a thermally conductive pad 33. The thermally conductive pad 33 is the thermally conductive pad described above. The thermally conductive pad is made of the foregoing thermal interface material. The heating piece 31 is located on a side of the radiator 32. The thermally conductive pad 33 is attached between the heating piece 31 and the radiator, so that the heating piece 31 dissipates heat by transmitting the heat to the radiator 32 by using the thermally conductive pad 33.

The following describes an embodiment of a method for preparing a thermal interface material according to an embodiment of this application.

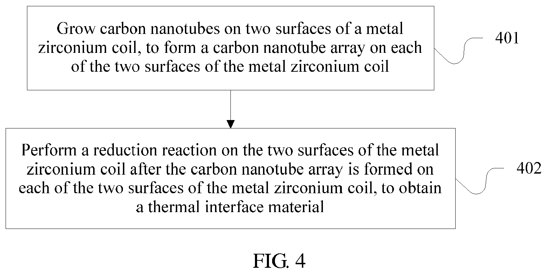

Referring to FIG. 4, an embodiment of a method for preparing a thermal interface material according to an embodiment of this application includes the following steps:

401. Grow carbon nanotubes on two surfaces of a metal zirconium foil, to form a carbon nanotube array on each of the two surfaces of the metal zirconium foil.

402. Perform a reduction reaction on the two surfaces of the metal zirconium foil after the carbon nanotube array is formed on each of the two surfaces of the metal zirconium foil, to obtain the thermal interface material.

The two surfaces of the metal zirconium foil in the thermal interface material include exposed metal zirconium.

In this embodiment, the reduction reaction is performed on the two surfaces of the metal zirconium foil after the carbon nanotube array is formed on each of the two surfaces of the metal zirconium foil, so that the two surfaces of the metal zirconium foil in the obtained interface material include the exposed metal zirconium. Therefore, interface thermal resistance of the thermal interface material is reduced, and a heat conducting property of the thermal interface material is improved.

In the present invention, both the two surfaces of the metal zirconium foil in the thermal interface material are the exposed metal zirconium. When both the two surfaces of the metal zirconium foil are the exposed metal zirconium, the interface thermal resistance of the thermal interface material is further reduced, and the heat conducting property of the thermal interface material is improved.

The performing a reduction reaction on the two surfaces of the metal zirconium foil includes:
placing, in an H2 atmosphere for annealing reduction processing, the metal zirconium foil with the carbon nanotube array grown on the two surfaces.

A reduction reaction can be performed on H2 by using an atom O in oxide on the surfaces of the metal zirconium foil, to generate H2O. Therefore, a good reduction effect is achieved, and the interface thermal resistance of the thermal interface material can be effectively reduced.

The inventor verifies through actual tests that, in a process of performing the annealing reduction processing in the H2 atmosphere, an optimal effect of performing the reduction reaction on the H2 by using the atom O in the oxide on the surfaces of the metal zirconium foil is achieved when an H2 flow rate is 5 to 100 SCCM, atmospheric pressure is 0.005 to 0.5 Mpa, annealing processing temperature is 350°C to 650°C, and duration of the annealing processing is 5 to 30 min.

The interface thermal resistance of the thermal interface material is mainly caused by air that is on an interface and that is between metal oxide on a surface of a metal substrate and a carbon nanotube. In addition, even in a high-density carbon nanotube array, there is still air between carbon nanotubes. Therefore, to reduce the interface thermal resistance of the thermal interface material, a material with higher heat conductivity may be used to replace the air and is filled between the carbon nanotubes. Optionally, after the performing a reduction reaction on the two surfaces of the metal zirconium foil, the method further includes:
filling a gap between two adjacent carbon nanotubes in the carbon nanotube array with resin in a vacuum by using an evaporation technology, to obtain the thermal interface material.

Optionally, a condition of the evaporation technology is that: temperature is 100°C to 300°C, and working atmospheric pressure is 5 to 50 Torr.

Optionally, the growing carbon nanotubes on two surfaces of a metal zirconium foil, to form a carbon nanotube array on each of the two surfaces of the metal zirconium foil includes:
after distributing metal particle catalysts on the two surfaces of the metal zirconium foil, placing, in a vacuum reaction chamber, the metal zirconium foil with the catalysts distributed on the two surfaces, where an airflow diffusion control apparatus is further disposed in the vacuum reaction chamber, the airflow diffusion control apparatus includes a first airflow diffusion control plate and a second airflow diffusion control plate, the first airflow diffusion control plate is located on a side of one surface of the metal zirconium foil, and the second airflow diffusion control plate is located on a side of the other surface of the metal zirconium foil; and
evenly injecting a mixed air source of C2H2 and Ar into the vacuum reaction chamber under control, where the mixed air source is blown to the one surface of the metal zirconium foil by using the first airflow diffusion control plate, and the mixed air source is blown to the other surface of the metal zirconium foil by using the second airflow diffusion control plate, to grow the carbon nanotubes on the two surfaces of the metal zirconium foil for 5 to 20 min and form the carbon nanotube array, where total atmospheric pressure in the vacuum reaction chamber is 10 to 100 Torr, and growth temperature is 500°C to 900°C.

Optionally, a distance between the first airflow diffusion control plate and the one surface of the metal zirconium foil is 0.1 mm to 20 mm, a size of a through hole on the first airflow diffusion control plate is 0.1 mm to 10.0 mm, and there is 1 to 100 through holes/cm2. Under such a condition, the mixed air source in the vacuum chamber is blown in an extremely narrow range. Therefore, an air flow can be relatively stable and even, so that the carbon nanotube array grows evenly.

Optionally, in the mixed air source, the C2H2 takes up 2% to 50%, and the Ar takes up 50% to 98%. A mixed air source within this proportion range can effectively ensure that the carbon nanotubes grow into a high-density carbon nanotube array.

It may be clearly understood by persons skilled in the art that, for the purpose of convenient and brief description, for a detailed working process of the foregoing system, apparatus, and unit, refer to a corresponding process in the foregoing method embodiments, and details are not described herein again. In the foregoing embodiments, the description of each embodiment has respective focuses. For a part that is not described in detail in an embodiment, refer to related descriptions in other embodiments.

It should be noted that, to make the description brief, the foregoing method embodiments are expressed as a series of actions. However, persons skilled in the art should appreciate that the present invention is not limited to the described action sequence, because according to the present invention, some steps may be performed in other sequences or performed simultaneously. In addition, persons skilled in the art should also appreciate that all the embodiments described in the specification are preferred embodiments, and the related actions and modules are not necessarily mandatory to the present invention.

The foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of the embodiments of the present invention.

## Claims

1. A method for preparing a thermal interface material, the method comprising:
• growing carbon nanotubes on two surfaces of a zirconium foil to form a carbon nanotube array on each of the two surfaces of the zirconium foil, wherein the two surfaces comprise zirconium oxide (step 401), and
• placing, in an H₂ atmosphere for annealing reduction processing, the zirconium foil with the carbon nanotube array grown on the two surfaces,
• performing the annealing reduction processing, wherein in the process of the annealing reduction processing in the H₂ atmosphere, an H₂ flow rate is ₅ to 100 SCCM, atmospheric pressure is 0.005 to 0.5 MPa, annealing processing temperature is 350°C to 650°C, and a duration of the annealing processing is 5 to 30 min, thereby performing a reduction reaction on the two surfaces of the zirconium foil after the carbon nanotube array is formed on each of the two surfaces of the zirconium foil to obtain the thermal interface material, wherein the two surfaces of the zirconium foil in the thermal interface material comprise, after the annealing reduction processing, on an interface between the zirconium foil and each carbon nanotube of the carbon nanotube array zirconium and on the remaining parts of the two surfaces exposed zirconium (step 402).

2. The method according to claim 1, wherein after the performing the reduction reaction on the two surfaces of the zirconium foil, the method further comprises:
filling a gap between two adjacent carbon nanotubes in the carbon nanotube array with resin in a vacuum by using an evaporation technology, to obtain the thermal interface material, so that the zirconium is no longer exposed between the two adjacent carbon nanotubes.

## Patentansprüche

1. Verfahren zum Vorbereiten eines Wärmeschnittstellenmaterials, wobei das Verfahren Folgendes umfasst:
- Aufwachsen von Kohlenstoffnanoröhren auf zwei Oberflächen einer Zirconiumfolie, um ein Kohlenstoffnanoröhrenarray auf jeder der zwei Oberflächen der Zirconiumfolie zu bilden, wobei die zwei Oberflächen Zirconiumoxid umfassen (Schritt 401), und
- Platzieren der Zirconiumfolie mit dem auf den zwei Oberflächen aufgewachsenen Nanoröhrenarray in einer H₂-Atmosphäre für eine Temperreduktionsverarbeitung,
- Durchführen der Temperreduktionsverarbeitung, wobei in dem Prozess der Temperreduktionsverarbeitung in der H2-Atmosphäre eine H2-Durchflussrate 5 bis 100 SCCM beträgt, ein atmosphärischer Druck 0,005 bis 0,5 MPa beträgt, eine Temperverarbeitungstemperatur 350 °C bis 650 °C beträgt und eine Dauer der Temperverarbeitung 5 bis 30 min beträgt, wodurch eine Reduktionsreaktion auf den zwei Oberflächen der Zirconiumfolie durchgeführt wird, nachdem das Kohlenstoffnanoröhrenarray auf jeder der zwei Oberflächen der Zirconiumfolie gebildet wurde, um das Wärmeschnittstellenmaterial zu erhalten, wobei die zwei Oberflächen der Zirconiumfolie in dem Wärmeschnittstellenmaterial nach der Temperreduktionsverarbeitung auf einer Grenzfläche zwischen der Zirconiumfolie und jeder Kohlenstoffnanoröhre des Kohlenstoffnanoröhrenarrays Zirconium und auf den verbleibenden Teilen der zwei Oberflächen freigelegtes Zirconium umfassen (Schritt 402).

2. Verfahren nach Anspruch 1, wobei das Verfahren nach dem Durchführen der Reduktionsreaktion auf den zwei Oberflächen der Zirconiumfolie ferner Folgendes umfasst:
Füllen eines Spalts zwischen zwei angrenzenden Kohlenstoffnanoröhren in dem Kohlenstoffnanoröhrenarray mit Harz in einem Vakuum durch Verwenden einer Aufdampftechnologie, um das Wärmeschnittstellenmaterial zu erhalten, so dass das Zirconium zwischen den zwei angrenzenden Kohlenstoffnanoröhren nicht mehr freigelegt ist.

## Revendications

1. Procédé pour la préparation d'un matériau d'interface thermique, le procédé comprenant :
• la croissance de nanotubes de carbone sur deux surfaces d'une feuille de zirconium pour former un réseau de nanotubes de carbone sur chacune des deux surfaces de la feuille de zirconium, les deux surfaces comprenant de l'oxyde de zirconium (étape 401), et
• le placement, dans une atmosphère de H₂ pour un traitement de réduction de recuit, de la feuille de zirconium comportant le réseau de nanotubes de carbone ayant crû sur les deux surfaces,
• la réalisation du traitement de réduction de recuit, dans lequel dans le processus du traitement de réduction de recuit dans l'atmosphère de H₂, un débit de H₂ est de 5 à 100 SCCM, la pression atmosphérique est de 0,005 à 0,5 MPa, la température de traitement de recuit est de 350 °C à 650 °C, et une durée du traitement de recuit est de 5 à 30 min, réalisant ainsi une réaction de réduction sur les deux surfaces de la feuille de zirconium après que le réseau de nanotubes de carbone est formé sur chacune des deux surfaces de la feuille de zirconium pour obtenir le matériau d'interface thermique, les deux surfaces de la feuille de zirconium dans le matériau d'interface thermique comprenant, après le traitement de réduction de recuit, sur une interface entre la feuille de zirconium et chaque nanotube de carbone du réseau de nanotubes de carbone, du zirconium et, sur les parties restantes des deux surfaces, du zirconium exposé (étape 402).

2. Procédé selon la revendication 1, dans lequel après la réalisation de la réaction de réduction sur les deux surfaces de la feuille de zirconium, le procédé comprend en outre :
le remplissage d'un espacement entre deux nanotubes de carbone adjacents dans le réseau de nanotubes de carbone avec une résine dans un vide en utilisant une technologie d'évaporation, pour obtenir le matériau d'interface thermique, de sorte que le zirconium n'est plus exposé entre les deux nanotubes de carbone adjacents.
